# EUROPEAN PATENT APPLICATION

(11) **EP 2 886 685 A1**
(43) Date of publication of application: **24.06.2015**
(21) Application number: 13198968.3
(22) Date of filing: 20.12.2013
(51) Int. Cl.: C25D 17/00, C25D 17/02, C23C 18/16, C25D 7/06, H05K 3/00

(54) **Device for accumulating a treatment liquid inside of a treatment area of a horizontal processing apparatus for a galvanic or wet-chemical metal deposition**

(71) Applicant: Atotech Deutschland GmbH, 10553 Berlin (DE)
(72) Inventor: Grüßner, Stefan, 91177 Thalmässing (DE); Wiener, Ferdinand, 90559 Burgthann (DE)
(74) Representative: Wonnemann, Jörg

(57) **Abstract**

The present invention is related to a device for accumulating a treatment liquid inside of a treatment area of a horizontal processing apparatus for a galvanic or wet-chemical metal deposition on a flat substrate to be treated, wherein the device comprises at least a liquid weir at the entry and/or at the exit of such a treatment area and a means of transport for transporting the flat substrates to be treated at a transport level through the horizontal processing apparatus, wherein the at least one liquid weir is arranged below the means of transport of the horizontal processing apparatus and below the transport level of the flat substrates to be treated; wherein the liquid weir is positioned in such a way that a gap between the upper surface of the liquid weir and the lower surface of the means of transport is adjustable and/or controllable.

The invention is further related to a method for galvanic or wet-chemical metal depositing on a flat substrate to be treated using such a device; and to the use of such a device for treating a flat substrate to be treated.

## Description

### Field of the Invention

The present invention relates to a device for accumulating a treatment liquid inside of a treatment area of a horizontal processing apparatus for a galvanic or wet-chemical metal deposition on a flat substrate to be treated, wherein the device comprises at least a liquid weir at the entry and/or at the exit of such a treatment area and a means of transport for transporting the flat substrates to be treated at a transport level through the horizontal processing apparatus.

The present invention is further directed to a method for galvanic or wet-chemical metal depositing on a flat substrate to be treated using such a device; and to the use of such a device for treating a flat substrate to be treated.

### Background of the Invention

It is known in the prior art that a substrate to be treated, which has to be processed through a horizontal apparatus for a galvanic or wet-chemical metal deposition, has to be transported through defined treatment areas of said apparatus, wherein a treatment liquid has to be accumulated by at least a liquid weir at the entry and/or at the exit of such a treatment area.

Conventionally, par example for classical printed circuit boards, such a substrate to be treated will be transported through the apparatus by rollers. The treatment liquid will be accumulated inside of the respective treatment area by liquid weirs. Such apparatuses have been patented and published by a plurality of companies like Höllmüller, Rena and Gebrüder Schmid GmbH.

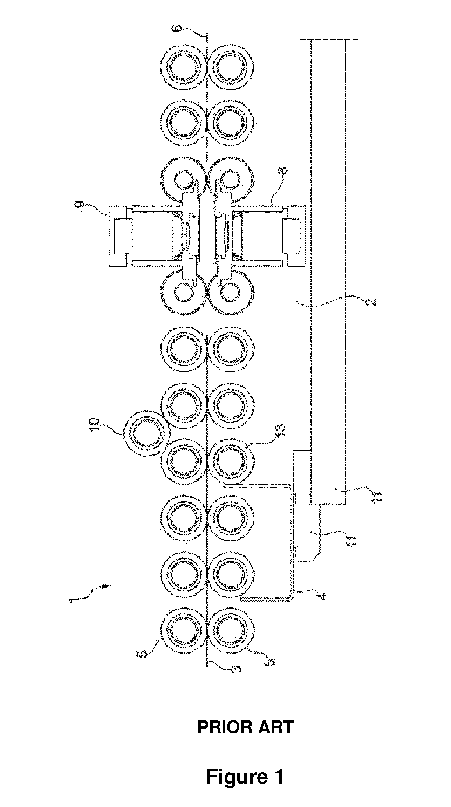

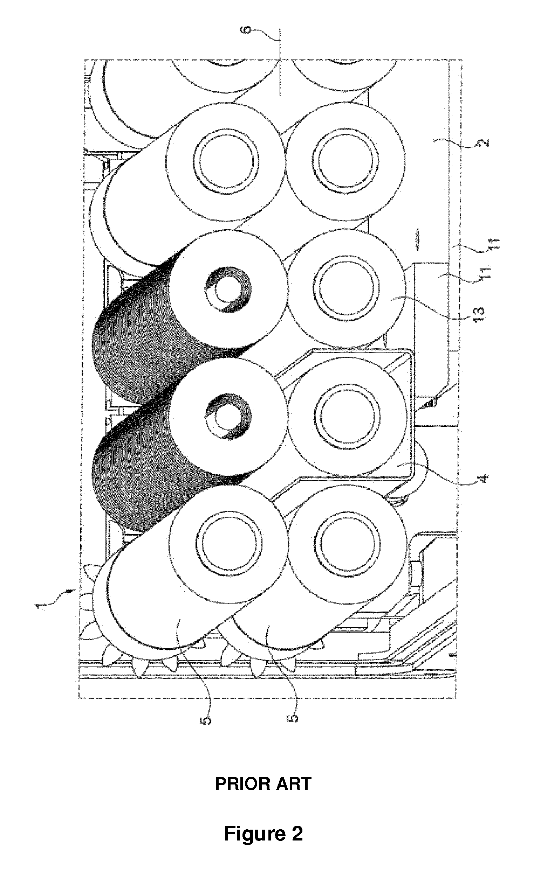

As it has been shown in Figures 1 and 2, a certain kind of liquid weir is normally used in order to ensure a sufficient treatment liquid flow to the underside of the substrates to be treated while they have been processed through the apparatus. These liquid weirs are normally placed between the rollers at the entry and/or at the exit of a treatment area; below the transport level of the horizontal apparatus. Such a position shall commonly ensure first a sufficient level of treatment liquid inside of the treatment area, and second a deflection of the flow of treatment liquid to the underside of the substrates to be treated.

The known devices comprising known liquid weirs are efficient and suitable for thick substrates to be treated, such as printed circuit boards, because they are heavy enough to avoid any undesired movement of themselves, which could be possibly generated by the deflection of treatment liquid by said known liquid weirs.

However, it is completely unknown to make use of a device comprising special liquid weirs, which have been especially developed to enable processing of thin and very thin substrates to be treated.

Such thin or very thin substrates to be treated cannot be processed by the known above-mentioned apparatuses comprising liquid weirs of the prior art as shown in Figures 1 and 2. If such a horizontal apparatus comprising such known liquid weirs is used for processing of such thin substrates to be treated, said thin substrates to be treated would execute undesired movements during their horizontal transport through the horizontal apparatus, such as creasing, crumpling; caused by turbulences at the underside of the substrates to be treated generated by the liquid weirs of the prior art.

This typically will significantly limit the degree of thickness to which substrates to be treated can be processed by such prior art apparatuses.

In the past, there has been one approach to solve this problem by making use of an additional drag plate, which is basically a heavy transportation panel, which has to be somehow fixed at the front of the substrate to be treated. Then, such thin substrates to be treated could be processed. But, this approach has several major drawbacks. First, additional costs are generated by additional manpower needed for the fixation of said drag plates at the substrates to be treated. Second, regardless if the metal deposition takes place as wet-chemical or galvanic process step, additional metal deposition on the surface of these drag plates cannot be avoided, thereby leading to a waste of chemicals, which again increases the costs. So, this approach can solely be seen as a compromise between the need of the industry to be able to process thin substrates and the absence of a device, which can ensure such processing without having the above-mentioned disadvantages in complexity and costs.

### Objective of the present Invention

In view of the prior art, it was thus an object of the present invention to provide a device for accumulating a treatment liquid inside of a treatment area of a horizontal processing apparatus for a galvanic or wet-chemical metal deposition on a flat substrate to be treated, which shall not exhibit the aforementioned shortcomings of the known prior art devices or apparatus, which can solely process relatively thick substrates to be treated.

### Summary of the Invention

This object and also further objects which are not stated explicitly but are immediately derivable or discernible from the connections discussed herein by way of introduction are achieved by a device having all features of claim 1. Appropriate modifications to the inventive device are protected in dependent claims 2 to 13. Further, claim 14 comprises a method for galvanic or wet-chemical metal depositing on a flat substrate to be treated using such a device; while claim 15 comprises the use of such a device for treating a flat substrate to be treated.

The present invention accordingly provides a device for accumulating a treatment liquid inside of a treatment area of a horizontal processing apparatus for a galvanic or wet-chemical metal deposition on a flat substrate to be treated, wherein the device comprises at least a liquid weir at the entry and/or at the exit of such a treatment area and a means of transport for transporting the flat substrates to be treated at a transport level through the horizontal processing apparatus, characterized in that the at least one liquid weir is arranged below the means of transport of the horizontal processing apparatus and below the transport level of the flat substrates to be treated; wherein the liquid weir is positioned in such a way that a gap between the upper surface of the liquid weir and the lower surface of the means of transport is adjustable and/or controllable.

It is thus possible in an unforeseeable manner to provide a device for accumulating a treatment liquid inside of a treatment area of a horizontal processing apparatus for a galvanic or wet-chemical metal deposition on a flat substrate to be treated, which does not exhibit the aforementioned shortcomings of the known prior art devices, which can solely process relatively thick substrates to be treated.

In addition thereto, the device of the present invention maximizes the efficiency of such a galvanic or wet-chemical metal deposition while at the same time the loss of substrates to be treated by mechanical damages caused by an unintentional movement of said substrates to be treated during processing can be minimized, or ideally even completely avoided.

Additionally, the device of the present invention offers an amended approach not solely for a treatment area in which a galvanic or wet-chemical treatment of a substrate to be treated takes place, but also offers a good solution wherever a kind of treatment liquid has to be accumulated. This includes all kind of possible pretreatment, post treatment and intermediate treatment steps in such a process for galvanic or wet-chemical treatment of a substrate to be treated, such as rinsing, cleaning, blind-hole or through-going conduits (p.e. TSV's) filling or cleaning in acid or basic medium.

In addition thereto, the device of the present invention does not solely offer a good solution for the object of the present invention, but the device is also adaptable to already existing systems. Hence, the device can also be applied in conventional horizontal apparatuses which mainly process conventional thick substrates to be treated like printed circuit boards wherein the above-described problems of unintentional movements and thereby caused mechanical damages of the substrates to be treated are not an issue. Thus, the device of the present invention is also very flexible applicable for broadening the possible application areas of conventional apparatuses, which have not yet been applied for such thinner substrates to be treated.

### Brief Description of the Figures

For a more complete understanding of the present invention, reference is made to the following Detailed Description of the Invention considered in conjunction with the accompanying figures, in which:
Fig. 1 exhibits a schematic side view of a part of a horizontal processing apparatus for a galvanic or wet-chemical metal deposition on a substrate to be treated of the prior art.
Fig. 2 exhibits a schematic perspective view of an entry part of a treatment area of a horizontal processing apparatus for a galvanic or wet-chemical metal deposition on a substrate to be treated of the prior art.

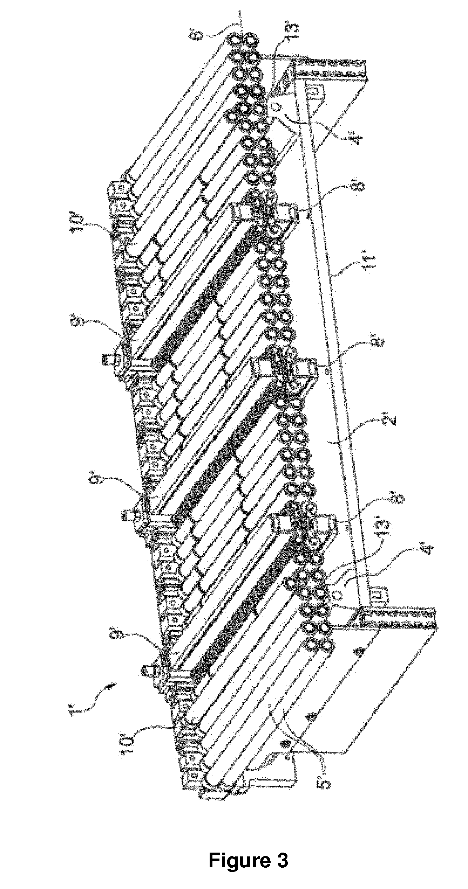

Fig. 3 exhibits a schematic perspective view of a device for accumulating a treatment liquid inside of a treatment area of a horizontal processing apparatus for a galvanic or wet-chemical metal deposition on a flat substrate to be treated in accordance with an embodiment of the present invention.

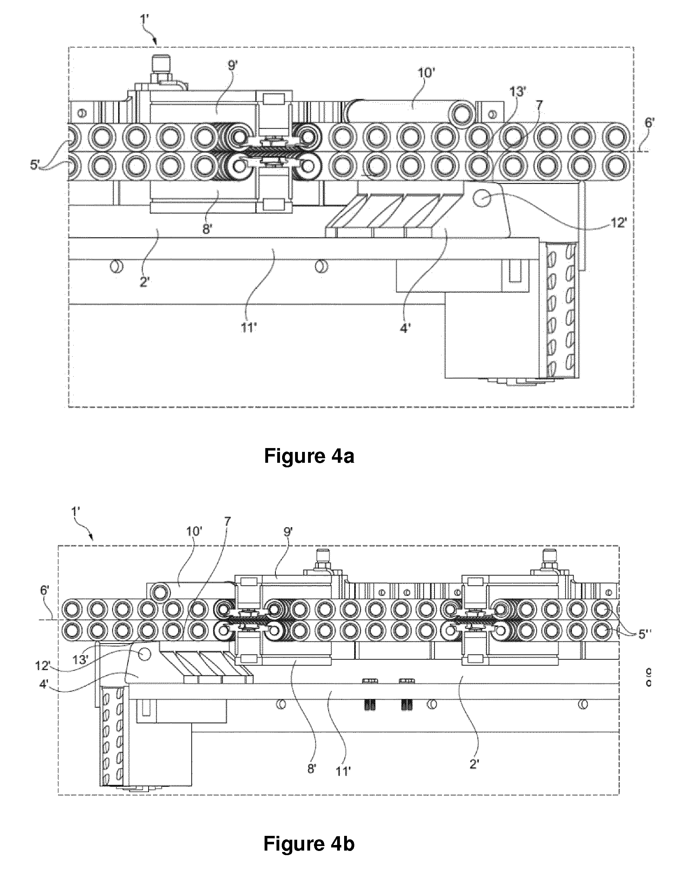

Fig. 4a exhibits a schematic perspective view of a part of the treatment area (inclusive the exit) of a device for accumulating a treatment liquid inside of a treatment area of a horizontal processing apparatus for a galvanic or wet-chemical metal deposition on a flat substrate to be treated in accordance with the embodiment of Figure 3.
Fig. 4b exhibits a schematic perspective view of a part of the treatment area (inclusive the entry) of a device for accumulating a treatment liquid inside of a treatment area of a horizontal processing apparatus for a galvanic or wet-chemical metal deposition on a flat substrate to be treated in accordance with the embodiment of Figure 3.

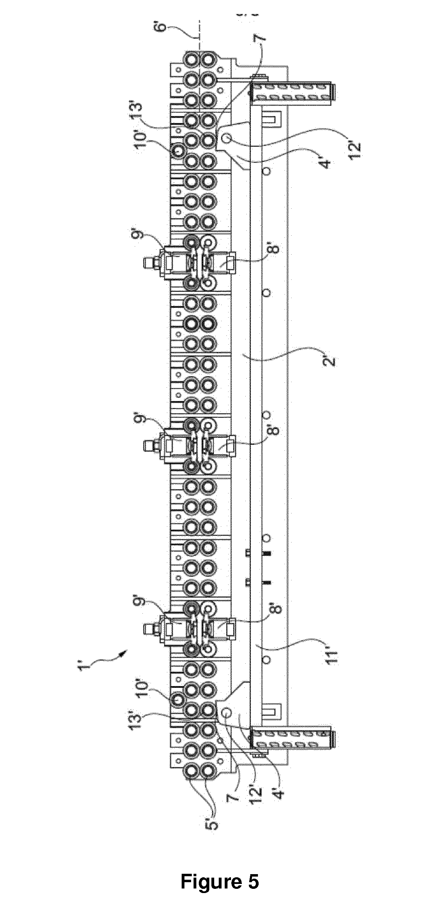

Fig. 5 exhibits a schematic side view of a device for accumulating a treatment liquid inside of a treatment area of a horizontal processing apparatus for a galvanic or wet-chemical metal deposition on a flat substrate to be treated in accordance with the embodiment of Figure 3.

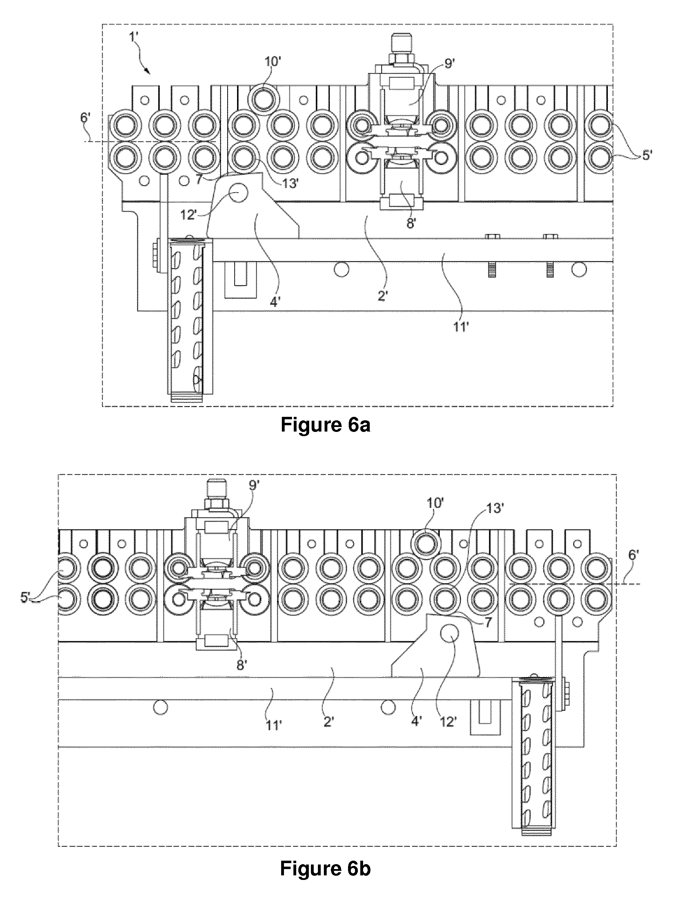

Fig. 6a exhibits a schematic side view of a part of the treatment area (inclusive the entry) of a device for accumulating a treatment liquid inside of a treatment area of a horizontal processing apparatus for a galvanic or wet-chemical metal deposition on a flat substrate to be treated in accordance with the embodiment of Figure 5.
Fig. 6b exhibits a schematic side view of a part of the treatment area (inclusive the exit) of a device for accumulating a treatment liquid inside of a treatment area of a horizontal processing apparatus for a galvanic or wet-chemical metal deposition on a flat substrate to be treated in accordance with the embodiment of Figure 5.

### Detailed Description of the Invention

As used herein, the term "device for accumulating a treatment liquid" in accordance with the present invention refers to a single module of a horizontal processing apparatus for a galvanic or wet-chemical metal deposition. Such a single module can be defined as any kind of module, wherein a treatment liquid has to be accumulated in a defined treatment area.

Such a treatment is not solely focused on the wet-chemical or galvanic metal deposition itself, but includes also many other possible treatments, which can play a role in the entire process of horizontal wet-chemical or galvanic metal deposition, like different pretreatment, intermediate treatment or post treatment steps, such as rinsing, etching, cleaning or blind-hole or through-going conduits (p.e. TSV's) filling or cleaning in acid or basic medium.

As used herein, the term "wet-chemical or galvanic metal", when applied to a wet-chemical or galvanic metal deposition on a substrate in accordance with the present invention, refers to metals, which are known to be suitable for such a deposition method, such as gold, nickel, and copper, preferably copper.

As used herein, the "flat substrate to be treated" is round, preferably circular, or angular, preferably polyangular, such as rectangular, quadratic or triangular, or a mixture of round and angular structure elements, such as semicircular; and/or the flat substrate to be treated has a diameter ranging from 50 mm to 1000 mm, preferably from 100 mm to 700 mm, and more preferably from 120 mm to 500 mm, in case of a round structure; or a side length ranging from 10 mm to 1000 mm, preferably from 25 mm to 700 mm, and more preferably from 50 mm to 500 mm, in case of an angular, preferably polyangular, structure and/or the flat substrate to be treated is a printed circuit board, a printed circuit foil, a semiconductor wafer, a wafer, a solar cell, a photoelectric cell, a flat panel display or a monitor cell. The flat substrate to be treated can be composed of one material or of a mixture of different materials, such as glass, plastics, molded compounds or ceramics.

In a preferred embodiment, the flat substrate can be an endless substrate in form of an endless conveyor, which is processed continuously through the entire horizontal apparatus. In this case, the flat substrate is composed of a flexible material, which allows winding up coils of the original material before the processing and winding in coils of the final material after processing.

The liquid weir at the entry and/or at the exit of such a treatment area shall ensure a proper accumulating of the treatment liquid inside of the treatment area. Therefore, it defines a barrier for the treatment liquid to allow solely a defined passing of a first partial volume flow out of the treatment area of the device. Hence, the gap between the upper surface of the liquid weir and the lower surface of the means of transport has to be adjustable and/or controllable in order to maintain or to establish such a first partial volume flow of the treatment liquid. A second partial volume flow flows upwards at the liquid weir to arrive the lower side of the substrates to be treated. Said two partial volume flows of the treatment liquid influences each other. If the gap is decreasing, the first partial volume flow is becoming smaller while the second partial volume flow becomes bigger and vice versa. So, it is decisive to be able to adjust and/or control the gap in order to avoid an undesired movement of the substrate to be treated, such as lifting up caused by a too strong second partial volume flow of the treatment liquid. Such an adjustment and/or control of the gap can also become necessary if the thickness of the flat substrate to be treated, which is going to be processed in the device, has changed or if another temperature of the treatment liquid is going to be applied. A large temperature increase or decrease can lead to thermal expansion or compression of the material of the liquid weir, which again influences the size of the respective gap between the upper surface of the liquid weir and the lower surface of the means of transport.

The transport level of the flat substrates to be treated is located above the liquid weir. The transport level of the flat substrates to be treated can be located above the transport means or between two parts of a transport means, such as between a lower series of rollers and a upper series of rollers.

In one embodiment, the liquid weir is positioned in such a way that the gap between the upper surface of the liquid weir and the lower surface of the means of transport is adjustable and/or controllable ranging from 0.05 mm to 0.5 mm, preferably from 0.08 mm to 0.25 mm, and more preferably from 0.1 mm to 0.15 mm.

In one embodiment, the liquid weir is adjustable and/or controllable by mechanical means of shift, such as cross slide, guide rod, stepper motor, preferably servomotor, or guide track.

In one embodiment, the liquid weir is adjustable and/or controllable by mechanical means of shift to execute a two-dimensional movement of said liquid weir by generating at least a first axial shift and at least a second axial shift of the liquid weir.

In a preferred embodiment, the at least first axial shift and the at least second axial shift of the liquid weir are perpendicular to each other.

In one embodiment, the upper surface of the liquid weir is aligned parallel to the transport level of the flat substrates to be treated above.

In one embodiment, the upper surface of the liquid weir is aligned non-parallel to the transport level of the flat substrates to be treated above.

In case that the upper surface of the liquid weir is aligned non-parallel to the transport level of the flat substrates to be treated above, the gap between the upper surface of the liquid weir and the lower surface of the means of transport is adjustable and/or controllable ranging from 0.05 mm to 0.5 mm, preferably from 0.08 mm to 0.25 mm, and more preferably from 0.1 mm to 0.15 mm; wherein the gap is measured from the lowest point of the upper surface of the liquid weir or from the highest point of the upper surface of the liquid weir or from a point of the upper surface of the liquid weir having an average height or from the point of the upper surface of the liquid weir which is located exactly below the lower surface of the means of transport.

In a preferred embodiment, the upper surface of the liquid weir comprises an angle ranging from 1 °to 10°, preferably from 1,5° to 5°, and more preferably from 2° to 3° related to a parallel alignment (0°).

In a more preferred embodiment, the upper surface of the liquid weir comprises at least two linear areas of different angle, at least one linear and at least one non-linear area, or at least two linear areas of different angle and at least one non-linear area.

In another embodiment, the liquid weir is a molded article comprising at least a first polymeric material, such as polypropylene.

Such a molded article can be formed as single piece or can be composed of at least two different single pieces.

The liquid weir can also comprise at least one material of metals, alloys or compound materials.

In one embodiment, the liquid weir comprises a molded article comprising at least a first polymeric material, such as polypropylene, and at least a second metal comprising material, such as stainless steel.

In one embodiment, the liquid weir comprises a molded article comprising polypropylene and at least a second metal comprising material, wherein the at least second metal comprising material is arranged as an enforcement along the longitudinal axis of the molded article, wherein the at least second metal comprising material is at least partially, preferably completely, surrounded by the first polymeric material.

In a preferred embodiment, the at least second metal comprising material can be replaced by any material, which provides stiffness to the liquid weir, such as ceramics, metals, alloys or polymeric materials.

In one embodiment, the flat substrate to be treated is a foil, wafer, printed circuit board, a glass substrate or an endless chain of a foil or another flat material.

In one embodiment, the flat substrate to be treated comprises a thickness of less than 75 µm, preferably of less than 50 µm, and more preferably less than 35 µm.

In one embodiment, the flat substrate to be treated comprises at least a covering layer, a protective layer, a metal layer or a composite layer composed of a plurality of individual layers of the same or different materials, preferably different materials.

In one embodiment, the means of transport can comprise rollers, tubes, shafts, clamps or wheels.

Further, the object of the present invention is also solved by a method for a galvanic or wet-chemical metal depositing on a flat substrate to be treated characterized by the following method steps:
i) Providing a device for accumulating a treatment liquid inside of a treatment area of a horizontal processing apparatus according to one of the preceding claims comprising a means of transport for transporting the flat substrates to be treated at a transport level through the horizontal processing apparatus.
ii) Providing at least a liquid weir at the entry and/or at the exit of a treatment area the horizontal processing apparatus, wherein said treatment area can comprise a pretreatment, a treatment or a post treatment module for a respective method step, such as rinsing, etching, cleaning or metal deposition.
iii) Arranging the at least one liquid weir below the means of transport of the horizontal processing apparatus and below the transport level of the flat substrates to be treated.
iv) Adjusting the position of the at least one liquid weir in such a way that a defined gap between the upper surface of the liquid weir and the lower surface of the means of transport is generated.
v) Executing the respective method step, such as rinsing, cleaning or metal deposition on the flat substrate to be treated.

Additionally, the object of the present invention is also solved by making use of such a device according to the present invention for treating a flat substrate to be treated.

Thus, the present invention thus addresses the problem of processing thin and very thin substrates to be treated in an horizontal processing apparatus for a galvanic or wet-chemical metal deposition, wherein conventional devices comprising conventional liquid weirs would lead to a severe damage of the processed thin substrates.

The following non-limiting examples are provided to illustrate an embodiment of the present invention and to facilitate understanding of the invention, but are not intended to limit the scope of the invention, which is defined by the claims appended hereto.

Turning now to the Figures, Figure 1 shows a schematic side view of a part of a horizontal processing apparatus for a galvanic or wet-chemical metal deposition on a substrate to be treated 3 of the prior art, whereas Figure 2 shows a schematic enlarged perspective view of the entry part of the treatment area 2 of the horizontal processing apparatus of Figure 1.

Hence, both Figures shall represent the known prior art, which is available at the moment in order to accumulate a treatment liquid inside of a treatment area 2 of a horizontal processing apparatus for a galvanic or wet-chemical metal deposition on a flat substrate to be treated 3.

Figure 1 exhibits the entry part of a device 1 for accumulating a treatment liquid in a treatment area 2, which is defined by its treatment area walls 11, wherein a liquid weir 4 of prior art is used for influencing the volume flow of treatment liquid in direction of the lower surface of the flat substrate to be treated 3.

As it can be derived from Figure 1 and Figure 2, the liquid weir 4 of prior art is arranged partially between the rollers 5, which represent in this example the means of transport 5. Further, there is a dam roller 10 positioned above the means of transport 5 in order to accumulate the treatment liquid in the treatment area 2 up to a level, which reaches at least the middle of the upper series of rollers 5, preferably which almost reaches the upper surface of the dam roller 10 itself. Of course, the level shall not be as high that the treatment liquid of the treatment area 2 could flow over the dam roller 10 and could leave thereby the treatment area 2.

For filling the treatment area 2, there is a bottom flooding element 8 and an upper flooding element 9, wherein the bottom flooding element 8 is arranged below the transport level 6 of the flat substrates to be treated 3 while the upper flooding element 9 is arranged above the transport level 6 of the flat substrates to be treated 3.

It shall again be highlighted that the liquid weir 4 of the prior art is arranged at least partially between the lower series of rollers 5, wherein the roller 13 has been highlighted as first element of means of transport 13, because the volume flow of treatment liquid is deflected by the liquid weir 4 completely in the upper direction to reach the lower surface of the substrates to be treated 3.

Turning now to the Figures 3 to 6, which represent a preferred embodiment of the present invention, the difference to the known prior art shown in Figures 1 and 2 is easily to detect. All Figures 3 to 6 comprise illustrations of the same device 1 of a preferred embodiment of the present invention.

Figure 3 shows a schematic perspective view of a device 1 for accumulating a treatment liquid inside of a treatment area 2 of a horizontal processing apparatus for a galvanic or wet-chemical metal deposition on a flat substrate to be treated in accordance with an embodiment of the present invention.

Figure 4a shows a schematic perspective view of a part of the treatment area (inclusive the exit) of the device 1 for accumulating a treatment liquid inside of a treatment area of a horizontal processing apparatus for a galvanic or wet-chemical metal deposition on a flat substrate to be treated in accordance with the embodiment of Figure 3.

Fig. 4b exhibits a schematic perspective view of a part of the treatment area (inclusive the entry) of a device for accumulating a treatment liquid inside of a treatment area of a horizontal processing apparatus for a galvanic or wet-chemical metal deposition on a flat substrate to be treated in accordance with the embodiment of Figure 3.

Fig. 5 exhibits a schematic side view of a device for accumulating a treatment liquid inside of a treatment area of a horizontal processing apparatus for a galvanic or wet-chemical metal deposition on a flat substrate to be treated in accordance with the embodiment of Figure 3.

Fig. 6a exhibits a schematic side view of a part of the treatment area (inclusive the entry) of a device for accumulating a treatment liquid inside of a treatment area of a horizontal processing apparatus for a galvanic or wet-chemical metal deposition on a flat substrate to be treated in accordance with the embodiment of Figure 5.

Fig. 6b exhibits a schematic side view of a part of the treatment area (inclusive the exit) of a device for accumulating a treatment liquid inside of a treatment area of a horizontal processing apparatus for a galvanic or wet-chemical metal deposition on a flat substrate to be treated in accordance with the embodiment of Figure 5.

As it can be derived from Figure 3 to 6, the liquid weir 4' of the present invention is arranged below the rollers 5', which represent in this preferred embodiment the means of transport 5'. Further, there is a dam roller 10' positioned above the means of transport 5' in order to accumulate the treatment liquid in the treatment area 2' up to a level, which reaches at least the middle of the upper series of rollers 5', preferably which almost reaches the upper surface of the dam roller 10' itself. Of course, the level shall not be as high that the treatment liquid of the treatment area 2' could flow over the dam roller 10' and could leave thereby the treatment area 2'.

For filling the treatment area 2', there are three bottom flooding elements 8' and three upper flooding elements 9', wherein the bottom flooding elements 8' are arranged below the transport level 6' of the flat substrates to be treated (not shown in the Figures) while the upper flooding elements 9' are arranged above the transport level 6' of the flat substrates to be treated (not shown in the Figures). Even if it is not explicitly shown in Figures 3 to 6, it is clear that the flat substrates to be treated are processed between the upper and the lower series of rollers 5' along the horizontal transport level 6'.

Further, Figures 3 to 6 shows an entire device 1' for accumulating a treatment liquid inside of a treatment area 2', wherein the device 1' comprises one liquid weir 4' at the entry and one liquid weir 4' at the exit of the treatment area 2'.

Both liquid weirs 4'are arranged below the means of transport 5' of the horizontal processing apparatus and below the transport level 6' of the flat substrates to be treated 3'; wherein both liquid weir 4' are positioned in such a way between the upper surface of the liquid weir 4' and the lower surface of the means of transport 5' in form of the roller 13' as first element of means of transport 13' that a gap 7 is generated.

Herein, the upper surface of both liquid weirs 4' are aligned non-parallel to the transport level 6' of the flat substrates to be treated above.

Additionally, the liquid weirs 4' comprise a molded article comprising two different materials, wherein the second material serves as enforcement 12' along the longitudinal axis of the molded article, wherein the second material is completely surrounded by the first material. In the preferred embodiment shown in Figures 3 to 6, the first material is polypropylene and the second material is stainless steel.

While the principles of the invention have been explained in relation to certain particular embodiments, and are provided for purposes of illustration, it is to be understood that various modifications thereof will become apparent to those skilled in the art upon reading the specification. Therefore, it is to be understood that the invention disclosed herein is intended to cover such modifications as fall within the scope of the appended claims. The scope of the invention is limited only by the scope of the appended claims.

### Reference signs

- 1, 1': Device for accumulating a treatment liquid
- 2, 2': Treatment area
- 3: Flat substrate to be treated
- 4, 4': Liquid weir
- 5, 5': Means of transport
- 6, 6': Transport level
- 7: Gap
- 8, 8': Bottom flooding element
- 9, 9': Upper flooding element
- 10, 10': Dam roller
- 11, 11': Treatment area wall
- 12': Enforcement of the liquid weir
- 13, 13': First element of means of transport

## Claims

1. Device (1') for accumulating a treatment liquid inside of a treatment area (2') of a horizontal processing apparatus for a galvanic or wet-chemical metal deposition on a flat substrate to be treated (3'), wherein the device (1') comprises at least a liquid weir (4') at the entry and/or at the exit of such a treatment area (2') and a means of transport (5') for transporting the flat substrates to be treated (3') at a transport level (6') through the horizontal processing apparatus, **characterized in that**
the at least one liquid weir (4') is arranged below the means of transport (5') of the horizontal processing apparatus and below the transport level (6') of the flat substrates to be treated (3'); wherein the liquid weir (4') is positioned in such a way that a gap (7) between the upper surface of the liquid weir (4') and the lower surface of the means of transport (5') is adjustable and/or controllable.

2. Device according to claim 1 **characterized in that** the liquid weir (4') is positioned in such a way that the gap (7) between the upper surface of the liquid weir (4') and the lower surface of the means of transport (5') is adjustable and/or controllable ranging from 0.05 mm to 0.5 mm, preferably from 0.08 mm to 0.25 mm, and more preferably from 0.1 mm to 0.15 mm.

3. Device according to claim 1 or 2 **characterized in that** the liquid weir (4') is adjustable and/or controllable by mechanical means of shift, such as cross slide, guide rod, stepper motor, preferably servomotor, or guide track.

4. Device according to one of the preceding claims **characterized in that** the liquid weir (4') is adjustable and/or controllable by mechanical means of shift to execute a two-dimensional movement of said liquid weir (4') by generating at least a first axial shift and at least a second axial shift of the liquid weir.

5. Device according to one of the preceding claims **characterized in that** the upper surface of the liquid weir (4') is aligned parallel to the transport level (6') of the flat substrates to be treated (3') above.

6. Device according to one of the preceding claims **characterized in that** the upper surface of the liquid weir (4') is aligned non-parallel to the transport level (6') of the flat substrates to be treated (3') above.

7. Device according to claim 6 **characterized in that** the upper surface of the liquid weir (4') comprises an angle ranging from 1 °to 10°, preferably from 1,5° to 5°, and more preferably from 2° to 3° related to a parallel alignment (0°).

8. Device according to one of the preceding claims **characterized in that** the liquid weir (4') is a molded article comprising at least a first polymeric material, such as polypropylene.

9. Device according to one of the preceding claims **characterized in that** the liquid weir (4') comprises a molded article comprising at least a first polymeric material, such as polypropylene, and at least a second metal comprising material, such as stainless steel.

10. Device according to one of the preceding claims **characterized in that** the liquid weir (4') comprises a molded article comprising polypropylene and at least a second metal comprising material, wherein the at least second metal comprising material is arranged as an enforcement (12') along the longitudinal axis of the molded article, wherein the at least second metal comprising material is at least partially, preferably completely, surrounded by the first polymeric material.

11. Device according to one of the preceding claims **characterized in that** the flat substrate to be treated (3') is a foil, wafer, printed circuit board, a glass substrate or an endless chain of a foil or another flat material.

12. Device according to one of the preceding claims **characterized in that** the flat substrate to be treated (3') comprises a thickness of less than 75 µm, preferably of less than 50 µm, and more preferably less than 35 µm.

13. Device according to one of the preceding claims **characterized in that** the means of transport (5') can comprise rollers, tubes, shafts, clamps or wheels.

14. Method for a galvanic or wet-chemical metal depositing on a flat substrate to be treated (3') **characterized by** the following method steps:
i) Providing a device (1') for accumulating a treatment liquid inside of a treatment area (2') of a horizontal processing apparatus according to one of the preceding claims comprising a means of transport (5') for transporting the flat substrates to be treated (3') at a transport level (6') through the horizontal processing apparatus.
ii) Providing at least a liquid weir (4') at the entry and/or at the exit of a treatment area (2') the horizontal processing apparatus, wherein said treatment area (2') can comprise a pretreatment, a treatment or a post treatment module for a respective method step, such as rinsing, etching, cleaning or metal deposition.
iii) Arranging the at least one liquid weir (4') below the means of transport (5) of the horizontal processing apparatus and below the transport level (6') of the flat substrates to be treated (3').
iv) Adjusting the position of the at least one liquid weir (4') in such a way that a defined gap (7) between the upper surface of the liquid weir (4') and the lower surface of the means of transport (5') is generated.
v) Executing the respective method step, such as rinsing, cleaning or metal deposition on the flat substrate to be treated (3').

15. Use of a device (1') according to one of the preceding claims 1 to 13 for treating a flat substrate to be treated (3').
